# EUROPEAN PATENT APPLICATION

(11) **EP 4 394 888 A1**
(43) Date of publication of application: **03.07.2024**
(21) Application number: 22217353.6
(22) Date of filing: 30.12.2022
(51) Int. Cl.: H01L 29/739, H01L 29/08, H01L 29/40, H01L 29/06

(54) **SEMICONDUCTOR DEVICE AND METHOD FOR PRODUCING A SEMICONDUCTOR DEVICE**

(71) Applicant: Hitachi Energy Ltd, 8050 Zürich (CH)
(72) Inventor: BUITRAGO, Elizabeth, 5210 Windisch (CH); BOKSTEEN, Boni Kofi, 5600 Lenzburg (CH); DE-MICHIELIS, Luca, 5000 Aarau (CH)
(74) Representative: Epping - Hermann - Fischer

(57) **Abstract**

The semiconductor device (100) comprises a semiconductor body (10) with a top side (11) and a bottom side (19). A first main electrode (2) is arranged on the top side and a second main electrode (3) is arranged on the bottom side. The semiconductor device comprises a gate electrode (4) and at least two trenches, namely a first-type trench (51) and a second-type trench (52). The semiconductor body comprises a drift region (14) of a first conductivity type and at least three base regions (13a, 13b, 13c) each of a second conductivity type. The semiconductor body further comprises an injection region (12) of the first conductivity type. The first main electrode is in electrical contact with the injection region. The gate electrode extends into the first-type trench. The second-type trench is free of the gate electrode. An electrically conductive layer (8) is arranged on the top side above the third base region and is electrically connected to an electrode. The electrically conductive layer is located close to the third base region so that it capacitively couples thereto.

## Description

The present disclosure relates to a semiconductor device and a method for producing a semiconductor device.

There is a need for an improved semiconductor device, for example a semiconductor device with improved static and/or dynamic behavior. Furthermore, there is a need for providing a method for producing such a semiconductor device.

Embodiments of the disclosure relate to a semiconductor device and a method for producing a semiconductor device.

First, the semiconductor device is specified.

According to an embodiment, the semiconductor device comprises a semiconductor body extending in vertical direction between a top side and a bottom side. A first main electrode is arranged on the top side and a second main electrode is arranged on the bottom side. Furthermore, the semiconductor device comprises a gate electrode and at least two trenches, namely a first-type trench and a second-type trench, each extending from the top side into the semiconductor body. The semiconductor body comprises a drift region of a first conductivity type arranged vertically between the top side and the bottom side and at least three base regions, namely a first, a second and a third base region, each of a second conductivity type and each arranged vertically between the drift region and the top side. The semiconductor body further comprises an injection region of the first conductivity type vertically spaced apart from the drift region by the first base region and adjoining the first base region. The first base region, the first-type trench, the second base region, the second-type trench and the third base region are arranged in this order one after the other in a first lateral direction. The first main electrode is in electrical contact with the injection region. The gate electrode extends into the first-type trench where it is separated from the semiconductor body by a gate insulation layer. The second-type trench is free of the gate electrode.

The arrangement with the second-type trench, the second base region and the third base region helps, inter alia, to protect the first-type trench, particularly the gate insulation layer therein, for example from avalanches during switching events.

The semiconductor device described herein may be a power semiconductor device. For example, it is configured to carry an electric current of at least 10 A and/or to process voltages of at least 1000 V or at least 3000 V. The semiconductor device may be a transistor device, particularly a gate insulated transistor device, particularly an IGFET.

The semiconductor body may be based on silicon or silicon carbide. The thickness of the semiconductor body, measured in vertical direction, is, for example, at least 100 µm or at least 200 µm and/or at most 500 µm. The top side and the bottom side are sides of the semiconductor body and delimit the semiconductor body in vertical direction.

The first and/or the second main electrode may comprise or consist of metal. Depending on the type of semiconductor device, the first electrode may herein also be called "emitter electrode" or "source electrode", respectively, and the second main electrode may be called "collector electrode" or "drain electrode", respectively.

The gate electrode may comprise metal and/or highly-doped polysilicon. The gate electrode is, in particular, an insulated gate electrode, i.e. it is electrically insulated from the semiconductor body. This may be achieved, for example, with the help of the gate insulation layer.

The trenches extend from the top side of the semiconductor body into the semiconductor body and end in the semiconductor body, for example in the drift region. The trenches may have the same depth, measured in vertical direction. The depths of the trenches may be at least 1 µm or at least 5 µm and/or at most 20 µm or at most 10 µm. The trenches may each be elongated and may each extend in a lateral direction, wherein lateral directions are herein defined as directions perpendicular to the vertical direction. Lateral directions are, in particular, directions parallel to a main extension plane of the semiconductor body. For example, the trenches extend parallel to each other.

The first-type trench and the second-type trench may be spaced apart from each other in a first lateral direction. Each trench may extend in a second lateral direction which is perpendicular to the first lateral direction. An average distance between the first-type trench and the second-type trench is, for example, at least 100 nm or at least 500 nm and/or at most 2 µm. The distance between two trenches is herein defined, for example, as the pitch between the trenches, i.e. the distance between the centers of the trenches. For example, no further trench is arranged laterally between the first-type trench and the second-type trench.

The first-type trench is filled with electrically conductive material which is separated from the semiconductor body by the gate insulation layer. The electrically conductive material is spatially and electrically separated from the semiconductor body by the gate insulation layer. The gate insulation layer may be an oxide, e.g. SiO₂. The thickness of the gate insulation layer may be at least 10 nm and/or at most 200 nm. For example, the thickness of the gate insulation layer is between 50 nm and 150 nm inclusive.

"Electrically separated" herein means, in particular, that there is no electrical contact between two elements. Two electrically separated elements are, for example, configured to be independently electrically biased or controlled, respectively. This means that they are configured to lie on different electrical potentials during operation of the semiconductor device. Two electrically separated elements may, in particular, be electrically insulated from each other, i.e. no current flow can occur between them.

The electrically conductive material in the first-type trench may be metal and/or highly-doped polysilicon. The electrically conductive material in the first-type trench is part of the gate electrode, i.e. is electrically connected to the gate electrode. When two elements are electrically connected or are in electrical contact, this means that these two elements are not independently electrically biasable or controllable. Thus, they always lie on the same electrical potential. The first-type trenches are herein also called active trenches.

For example, the electrically conductive material in the first-type trench reaches at least as deep into the semiconductor body as the first base region and/or as the second base region.

The second-type trench is free of the gate electrode. That is, the second-type trench is a gate electrode free trench. In other words, the second-type trench is electrically separated from the gate electrode.

The second-type trench may also be filled with electrically conductive material, which may be separated from the semiconductor body by an insulation layer. However, this electrically conductive material is electrically separated from the gate electrode, i.e. not electrically connected thereto. The insulation layer can be the same as the gate insulation layer. Within the second-type trench, the electrically conductive material may reach as deep into the semiconductor body as the first and/or second base region. The electrically conductive material in the second-type trench may be metal and/or highly-doped polysilicon.

For example, the electrically conductive material in the second-type trench is electrically connected to the first main electrode. In other words, the first main electrode may extend into the second-type trench.

Instead of being filled with electrically conductive material, the second-type trench could be free of electrically conductive material and may, for example, only be filled with an electrically isolating material.

The second-type trench is herein also called "inactive trench".

The drift region of the semiconductor body is of a first conductivity type. The first conductivity type is, for example, n-type, i.e. the drift region is n-doped. The second conductivity type is opposite to the first conductivity type and, therefore, may be p-type. However, the opposite case, in which the first conductivity type is p-type and the second conductivity type is n-type, may also be realized.

The drift region extends, for example, contiguously over all base regions. That is, in top view onto the top side, the drift region overlaps with all three base regions.

The first-type trench is arranged between the first base region and the second base region in the first lateral direction. For example, the first-type trench adjoins the first base region on one side and/or the second base region on the other side.

The second base region is arranged between the first-type trench and the second-type trench in the first lateral direction. The second base region may adjoin the second-type trench. The second base region may extend continuously, for example without interruptions, from the first-type trench to the second-type trench.

The second-type trench is arranged between the second base region and the third base region in the first lateral direction. The second-type trench may adjoin the third base region.

The third base region may extend continuously, e.g. without interruptions, from the second-type trench to a further trench which is spaced apart from the second-type trench in the first lateral direction. The further trench may be another second-type trench, i.e. electrically separated from the gate electrode or not filled with the gate electrode, respectively.

The structure comprising the first base region and the adjoining injection structure, the first-type trench, the second base region, the second-type trench and the third base region may be repeated several times along the top side. The structure comprising a at least a portion (half) of the first base region together with the adjoining injection region, the first-type trench, the second base region, the second-type trench and a portion (half) of the third base region is also called "half-cell" or "transistor half-cell". The semiconductor device may comprise several such half-cells which may be arranged one after the other in the first lateral direction. Each two adjacent half-cells may be mirror-symmetric with respect to a mirror plane. The mirror planes extend, for example, perpendicular to the first longitudinal direction. Mirror planes may cross the first and/or the third base regions at half their respective extensions in the first lateral direction.

The semiconductor body comprises an injection region of the first conductivity type. The injection region is vertically spaced apart from the drift region by the first base region and adjoins the first base region. The injection region reaches, for example, to the top side. The injection region may be embedded in the first base region. For example, the injection region adjoins the first-type trench at the same side as the first base region adjoins the first-type trench. Each half-cell may comprise exactly one such injection region. The injection region is also referred to as source region.

The injection region is in electrical contact with the first main electrode, for example it adjoins the first main electrode. During operation of the semiconductor device in a (static) transistor mode, first-type charge carriers, e.g. electrons, are injected from the first main electrode into the injection region. The semiconductor device is configured such that, by applying a certain potential to the gate electrode, the first base region adjacent to the first-type trench is depleted so that a path for the first-type charge carriers from the injection region towards the drift region is formed, said path extending in vertical direction along the first-type trench.

The second base region may form part of the top side, e.g. the entire portion of the top side which is located laterally between the first-type trench and the second-type trench. For example, the semiconductor body is free of any (injection) region of the first conductivity type arranged vertically between the second base region and the top side and adjoining the second base region.

The third base region may also form part of the top side, e.g. the entire portion of the top side which is located laterally between the two trenches which laterally delimit the third base region. The semiconductor body may be free of any (injection) region of the first conductivity type arranged vertically between the third base region and the top side and adjoining the third base region.

According to a further embodiment, the semiconductor body comprises an electrically conductive layer which is arranged on the top side of the semiconductor body above the third base region. The electrically conductive layer is electrically connected to an electrode of the semiconductor device which is different from the gate electrode. This means that the electrically conductive layer is configured to be electrically biased/controlled independently of the gate electrode, i.e. it can be set to an electrical potential which is different from that of the gate electrode.

The electrically conductive layer on the top side above the third base region may comprise or consist of metal and/or highly-doped polysilicon. For example, the electrically conductive layer is electrically connected to the first main electrode or is connected to an electrode independently controllable/biasable of the first main electrode.

In top view onto the top side, the electrically conductive layer and the third base region overlap with each other, at least partially. That is, in top view onto the top side, the electrically conductive layer covers at least a portion of the third base region. The electrically conductive layer may be a contiguous layer or may be formed of several segments spaced apart from one another in at least one lateral direction. The electrically conductive layer extends, in particular, parallel to the top side and/or parallel to the main extension plane of the semiconductor body.

According to a further embodiment, the electrically conductive layer is located so close to the third base region that, by electrically biasing the electrically conductive layer, such a strong capacitive coupling between the third base region and the electrically conductive layer can be achieved that free charge carriers in the third base region are influenced thereby. "Influenced" means, for example, that free charge carriers are attracted or repelled by the electrically conductive layer. In particular, the free charge carriers are second-type charge carrier according to the conductivity type of the third base region. Thus, the free charge carriers may be holes in the case that the third base region is p-doped.

Such an electrically conductive layer enables the operation of the semiconductor device to be improved. For instance, during static operation, free charge carriers in the third base region can be repelled by the electrically conductive layer in order to keep an electron-hole plasma in the semiconductor body high or in order to shift it towards the gate electrode in the first-type trench. When switching the semiconductor device, the second-type charge carriers can be attracted by the electrically conductive layer in order to draw the electron-hole plasma away from the first-type trench. This reduces the risk of damage to the gate insulation layer in the first-type trench due to avalanches, for example.

The maximum distance between the third base region and the electrically conductive layer for achieving such a strong capacitive coupling depends on several factors, like the potential which is applied to the electrically conductive layer, the material arranged vertically between the electrically conductive layer and the semiconductor body on the lateral extension of the electrically conductive layer. For example, the maximum vertical distance between the electrically conductive layer and the third base region is in the same order of magnitude as the thickness of the gate insulation layer.

According to a further embodiment, the electrically conductive layer is spaced apart from the top side of the semiconductor body by an electrically isolating layer arranged vertically between the top side and the electrically conductive layer. The electrically isolating layer may be of an oxide. For example, it is of the same material as the gate insulation layer. For example, the electrically isolating layer is of SiO₂.

For example, the electrically conductive layer is spaced apart from the top side solely by the electrically isolating layer. That is, the vertical distance between the top side and the electrically conductive layer is defined by the thickness of the electrically isolating layer. The electrically isolating layer may fill the major part between the electrically conductive layer and the top side of the semiconductor body. For example, at least 70% or at least 80% or at least 90% of the volume between the electrically conductive layer and the top side is filled by the electrically isolating layer.

According to a further embodiment, the thickness of the electrically isolating layer is at most five times or at most three times or at most 1.5 times greater than the thickness of the gate insulation layer.

According to a further embodiment, the vertical distance between the electrically conductive layer and the third base region is at most 500 nm or at most 300 nm or at most 150 nm. Additionally or alternatively, the vertical distance between the electrically conductive layer and the third base region may be at least 10 nm or at least 50 nm. This minimum distance is present at least in certain areas of the electrically conductive layer.

According to a further embodiment, the electrically conductive layer and the third base region are electrically separated from each other. That is, the semiconductor device is free of a (direct) electrical connection between the electrically conductive layer and the third base region. For example, the electrically isolating layer then extends contiguously and without interruptions between the electrically conductive layer and the top side of the semiconductor body and extends over the entire lateral extension of the electrically conductive layer.

According to a further embodiment, an electrical connection is formed between the electrically conductive layer and the third base region. For example, the electrically conductive layer is in electrical contact with the third base region in one or more contact areas of the third base region. In these contact areas, the electrically conductive layer may adjoin the third base region. When viewed in top view onto the top side, the total area of the contact areas is, for example, at most 50% or at most 30% or at most 10% of the area of the electrically conductive layer. The rest of the electrically conductive layer, i.e. outside of the contact areas, is, for example, spaced apart from the semiconductor body, for example by the electrically isolating layer.

According to a further embodiment, in top view onto the top side, the electrically conductive layer covers a major part of the third base region. For example, in this plan view, the electrically conductive layer covers at least 60% or at least 80% or at least 90% of the third base region. Additionally or alternatively, in this top view, the electrically conductive layer does not overlap with the second-type trench and/or does not overlap with any of the trenches laterally delimiting the third base region. It is also possible that, in this top view, the electrically conductive layer overlaps with the second-type trench or with any one of the trenches laterally delimiting the third base region, but does not extend laterally beyond this/these trench(es).

According to a further embodiment, the electrically conductive layer is arranged vertically between the top side of the semiconductor body and a portion of the emitter electrode. For example, in top view onto the top side, the portion of the emitter electrode and the electrically conductive layer overlap with each other. For example, the portion of the emitter electrode completely covers the electrically conductive layer in this top view.

According to a further embodiment, the vertical distance between the electrically conductive layer and the third base region is at most half or at most 1/5 or at most 1/10 of the vertical distance between the portion of the emitter electrode and the top side of the semiconductor body. Particularly, the portion of the emitter electrode is so far away from the third base region that it does not couple capacitively to the third base region.

For example, the vertical distance between the portion of the emitter electrode and the top side is at least 800 nm or at least 1 µm or at least 1.5 µm.

There may be a further electrically isolating layer arranged vertically between the top side of the semiconductor body and the portion of the emitter electrode. The thickness of this further electrically isolating layer may define the distance between the portion of the emitter electrode and the top side. The further electrically isolating layer may be of an oxide, like SiO2. It is herein referred also to as field insulation layer.

According to a further embodiment, the semiconductor device is operable in a first mode in which free charge carriers, particularly second-type charge carriers, e.g. holes, in the third base region are repelled by the electrically conductive layer. For example, in the first mode, the electrically conductive layer is on a positive electrical potential.

According to a further embodiment, the semiconductor device is operable in a second mode in which free charge carriers, particularly second-type charge carriers, e.g. holes, in the third base region are attracted by the electrically conductive layer. For example, in the second mode, the electrically conductive layer is on negative electrical potential.

According to a further embodiment, the first mode is a transistor mode and/or the second mode is a diode mode. That is, in the first mode, the semiconductor device is operated as a transistor and, in the second mode, the semiconductor device is operated as a diode.

For example, in the first mode, the gate electrode and the first main electrode are on different electrical potentials. In the transistor mode, the first main electrode may be on positive potential relative to the second main electrode. In the diode mode, this may be reversed, i.e. the first main electrode is on negative potential relative to the second main electrode.

According to a further embodiment, the third base region comprises at least one contact area in which the third base region is in electrical contact with an electrode of the semiconductor device which is different from the gate electrode, e.g. it is controllable/biasable independently of the gate electrode.

During operation, charge carriers can be extracted from the semiconductor body via the contact area. The contact area may, therefore, also be called "extraction area". Such an extraction area can be advantageous during switching events, e.g. during turn-off of a transistor mode, as it helps to quickly reduce the plasma concentration in the semiconductor body. That is, the contact area constitutes a plasma control feature. On the other hand, if the semiconductor device is operated in a diode mode, the electrical contact of the electrode and the semiconductor body in the contact area provides an (additional) charge carrier path(s) which reduces on-state losses in the diode mode. Since the contact area is in electrical contact with an electrode which is different from the gate electrode, the path for the charge carriers is independent of the gate electrode potential. The location of the contact area of the third base region, i.e. at a place which is spaced apart from the first-type trench by a second-type trench, helps to protect the gate insulation layer in the first-type trench during switching events because the creation of avalanches in the region of the first-type trench is reduced.

For example, the electrode to which the third base region is electrically connected in the contact area is arranged on the top side. The electrode may be the first main electrode, or another electrode which is independently controllable of the first main electrode.

Since the contact area belongs to the third base region, it is herein also referred to as third contact area. The contact area may form part of the top side. The third base region may adjoin the electrode over the entire area of the contact area. When seen in top view onto the top side, the area of the contact area is, in particular, smaller than the area of the third base region. For example, in this top view, the area of the contact area is at most 50% or at most 10% or at most 5% or at most 1% of the area of the third base region. In the case of several contact areas, all features disclosed for one contact area are also disclosed for the other contact areas.

According to a further embodiment, the semiconductor device is an RC-IGBT, i.e. reverse-conducting IGBT, or a MISFET, particularly a MOSFET.

RC-IGBTs and MOSFETs are semiconductor devices which can be operated in a diode mode. For such devices, the contact area in which the third base region is in electrical contact with an electrode is particularly beneficial, as explained above.

According to a further embodiment, the at least one contact area and the electrically conductive layer are electrically connected to the same electrode, e.g. to the first main electrode.

According to a further embodiment, the electrically conductive layer comprises at least two sections which are spaced apart from one another in a lateral direction.

According to a further embodiment, the at least one contact area is arranged laterally between the two sections of the electrically conductive layer. For example, in top view onto the top side, the at least two sections do not overlap with the contact area. The contact are may be arranged in the gap between the two sections when viewed in this top view.

According to a further embodiment, the third base region comprises a plurality of (third) contact areas. The third base region is in electrical contact with the electrode in each of these contact areas. For example, the contact areas of the third base region are spaced apart from each other in at least one lateral direction, for example in the first lateral direction. All features disclosed in connection with one contact area of the third base region are also disclosed for all other contact areas of the third base region.

The contact areas of the third base region may each be formed as a stripe, e.g. extending in the second lateral direction. Each two contact areas of the third base region may be spaced apart from each other. In the regions outside of the contact areas there is no direct electrical contact between the electrode and the third base region. Particularly, outside of the contact areas, the electrode does not adjoin the third base region. For example, the plurality of contact areas of the third base region is arranged in a rectangular pattern when viewed in top view onto the top side. For example, at most 50% and/or at least 10% of the area of the third base region, when seen in this top view, is formed by the contact areas.

According to a further embodiment, in top view onto the top side, the at least one contact area in the third base region and the electrically conductive layer overlap with each other. For example, in the contact area the third base region is electrically conductively connected to the electrically conductive layer.

Alternatively, a hole may be formed through the electrically conductive layer through which the electrode in contact with the third base region in the contact area is guided. Within the hole, the electrode may be spaced apart from the electrically conductive layer, e.g. by the electrically isolating layer.

According to a further embodiment, the third base region extends from the top side at least as deep into the semiconductor body as the second-type trench and/or as the first-type trench. For example, the third base region extends deeper into the semiconductor body than the second-type trench and/or than the first-type trench. It has been found that, with such a design, the avalanche intensity near the first-type trench can be significantly reduced.

According to a further embodiment, the first-type trench and the second-type trench have the same depth. Alternatively, the second-type trench may extend deeper into the semiconductor than the first-type trench. It has turned out that such a deeper second-type trench further helps to keep avalanches away from the first-type trench.

According to a further embodiment, the third base region extends below the second-type trench towards the first-type trench. Thus, in top view onto the top side, the second-type trench and the third base region may overlap with each other.

According to a further embodiment, the second base region comprises at least one contact area in which the second base region is in electrical contact with an electrode of the semiconductor device which is different from the gate electrode. This electrode may be the same electrode which is in electrical contact with the third base region in the respective (third) contact area. The contact area of the second base region, herein also referred to as second contact area, may form part of the top side. The second contact area may have a smaller area than the area of the second base region when seen in top view onto the top side. The same relative sizes as disclosed in connection with the (third) contact area of the third base region may apply here as well.

With the contact area of the second base region, a further degree of freedom for optimizing charge-carrier extraction, e.g. during turn-off of the transistor mode and/or during the diode mode is realized.

According to a further embodiment, the first base region comprises at least one contact area in which the first base region is in electrical contact with an electrode of the semiconductor device which is different from the gate electrode. Also this electrode may be the same electrode which is in electrical contact with the third base region in the respective (third) contact area. The contact area of the first base region, herein also called first contact area, may adjoin the top side and/or the injection region.

With the contact area of the first base region, another degree of freedom for optimizing charge carrier extraction, e.g. during the turn-off of the transistor mode and/or during diode mode, is realized.

Since in each case the contact areas are part of the respective base region, they are of the second-conductivity type. In each base region, the at least one contact area may be spaced apart from the trenches laterally delimiting the respective base region.

Next, the method for producing a semiconductor device is specified. For example, the semiconductor device as specified herein can be produced with this method. Therefore, all features disclosed in connection with the semiconductor device are also disclosed for the method and vice versa.

According to an embodiment, the method for producing a semiconductor device comprises a step in which a semiconductor body with a top side and a bottom side is provided. Then, at least two trenches, namely a first-type trench and a second-type trench, are formed in the semiconductor body, wherein each of the trenches extends from the top side into the semiconductor body. Furthermore, a first main electrode is formed on the top side and a second main electrode is formed on the bottom side of the semiconductor body. A gate electrode is formed such that the gate electrode extends into the first-type trench where it is separated from the semiconductor body by the gate insulation layer. The second-type trench is kept free of the gate electrode. The semiconductor device is formed such that the semiconductor body comprises a drift region of a first conductivity type arranged vertically between the top side and the bottom side and at least three base regions, namely a first, a second and a third base region, each of a second conductivity type and each arranged vertically between the drift region and the top side. The semiconductor body further comprises an injection region of the first conductivity type, vertically spaced apart from the drift region by the first base region and adjoining the first base region. The first base region, the first-type trench, the second base region, the second-type trench and the third base region are arranged in this order one after the other in a first lateral direction. The first main electrode is in electrical contact with the injection region.

The trenches may be formed in the semiconductor body before the base regions and the injection region are formed. Alternatively, the base regions may be at least partially formed before the trenches are formed.

According to a further embodiment, an electrically conductive layer is formed on the top side. The electrically conductive layer is arranged above the third base region and is electrically connected to an electrode of the semiconductor device which is different from the gate electrode. The electrically conductive layer is located so close to the third base region that, by electrically biasing the electrically conductive layer, such a strong capacitive coupling between the third base region and the electrically conductive layer can be achieved that free charge carriers in the third base region are influenced thereby.

Hereinafter, the semiconductor device and the method for producing a semiconductor device will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.
Figures 1 to 8 and 12 show different exemplary embodiments of the semiconductor device in different views,
Figures 9 to 11 show different positions in an exemplary embodiment of the method for producing a semiconductor device.

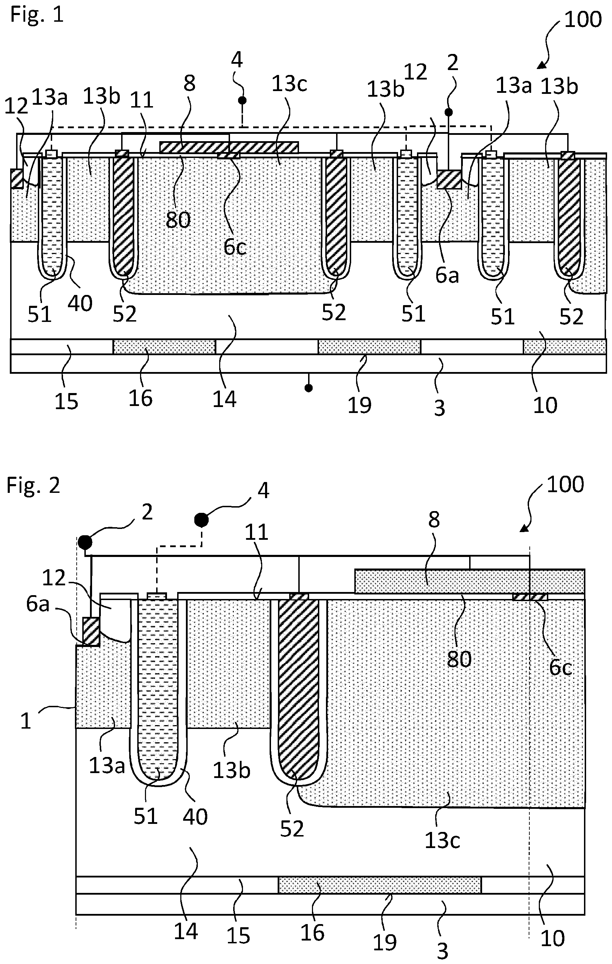

Figure 1 shows a first exemplary embodiment of the semiconductor device 100 in a cross-sectional view. The semiconductor device 100 is, in this case, an RC-IGBT. It comprises a semiconductor body 10 with a top side 11 and a bottom side 19, lying opposite to each other in a vertical direction. The semiconductor body 10 is based on Si or SiC, for example.

At the bottom side 19, the semiconductor body 10 comprises first-type regions 15 and second-type regions 16, which are arranged in an alternating manner. The regions 15 and 16 are in electrical contact with a second main electrode 3, namely a collector electrode 3, on the bottom side 19. The collector electrode 3 is, for example, formed of metal.

The first-type regions 15 are of a first conductivity type, which is n-type in the following, and the second-type regions 16 are of a second conductivity type, which is p-type in the following. A drift region 14 is arranged between the top side 11 and the bottom side 19. The drift region 14 is of the first conductivity type, i.e. n-type. The drift region 14 adjoins the first-type 15 and the second-type 16 regions.

A plurality of trenches 51, 52 extends from the top side into the semiconductor body 10 and into the drift region 14. The trenches 51 are first-type trenches, herein also called active trenches, and the trenches 52 are second-type trenches, herein also called inactive trenches or dummy trenches.

The first-type trenches 51 are filled with an electrically conductive material which is electrically separated from the semiconductor body 10 by an electrically insulating layer 40, herein called "gate insulation layer". Thus, there is no direct electrical contact between the semiconductor body 10 and the electrically conductive material in the first-type trenches 51. The gate insulation layer 40 is, for example, formed of an oxide, like SiO₂. The electrically conductive material in the first-type trenches 51 may be a highly-doped polysilicon. The electrically conductive material in the first-type trenches 51 is part of a gate electrode 4 of the semiconductor device 100.

The second-type trenches 52 are also filled with electrically conductive material, e.g. highly-doped polysilicon, which is also electrically separated from the semiconductor body 10 by an electrically insulating layer which is the same as the gate insulation layer 40. The electrically conductive material in the second-type trenches 52 is part of a first main electrode 2, namely an emitter electrode 2, arranged on the top side 12.

The semiconductor body 10 comprises several base regions 13a, 13b, 13c, which are arranged vertically between the drift region 14 and the top side 11. The base regions 13a, 13b, 13c are all of the second conductivity type, i.e. p-type, and they all adjoin the drift region 14 as well as the top side 11. First 13a and second 13b base regions are shallower (smaller vertical extension) than the trenches 51, 52. The third base region 13c is deeper than the trenches 51, 52, i.e. extends further into the semiconductor body 10.

The first base regions 13a adjoin and are in electrical contact with the emitter electrode 2 in a first contact area 6a, also called "Rb-prime areas". The third base region 13c adjoins and is in electrical contact with the emitter electrode 2 in a third contact area 6c. The function of these contact areas 6a, 6c will be explained further below.

As can be seen in figure 1, the semiconductor device 100 is subdivided into a plurality of so-called half-cells. One such half-cell is shown in greater detail in figure 2. The half-cell is the structure between the vertical dashed lines in figure 2. In figure 1, several such half-cells are arranged one after the other in a first lateral direction, running from the left to the right. Two adjacent half-cells are mirrored with respect to each other at the plane running perpendicularly to the first lateral direction and through the third base region 13c (see right vertical dashed line in figure 2).

As can be seen in figure 2, the half-cell comprises a portion (half) of a first base region 13c, a first-type trench 51, a second base region 13b, a second-type trench 52 and a portion (half) of a third base region 13c which are arranged one after the other in this order along the first lateral direction. The half-cell further comprises an injection region 12 (source region 12) of the first conductivity type, i.e. n-type, arranged vertically between the first base region 13c and the top side 11. The injection region 12 adjoins the first base region 13c and the first-type trench 51. The injection region 12 further adjoins the emitter electrode 2 and is in electrical contact therewith.

The operation of the semiconductor device may be as follows:
In a so-called transistor mode, the emitter electrode 2 is set to ground and the collector electrode 3 is set to a positive potential. The gate electrode 4 is set to a positive potential so that the first base region 13a is depleted at the border to the first-type trench 51. A conduction path is created in the first base region 13c along the first-type trench 51. Electrons can then be injected from the emitter electrode 2 into the injection region 12, can travel along the conduction path, and reach into the drift region 14. On the bottom side 19, holes are injected from the collector electrode 3 via the second-type regions 16 and also travel into the drift region 14 so that an electron-hole plasma is created.

When turning off of the transistor mode, the electron-hole plasma can create avalanches in the region of the first-type trench 51. Such avalanches can, in turn, harm the gate insulation layer 40 so that the long-term performance stability of the semiconductor device 10 is negatively affected. It has been found that the second-type, inactive trench 52, and the third base region extending deeper into the semiconductor body than the trenches 51, 52, help to divert avalanches away from the active trench.

This effect is additionally increased by the third base region 13c being in electrical contact with the emitter electrode 2 in the third contact area 6c. Charge carriers, e.g. holes, can be dissipated via this third contact area 6c during turnoff.

Since the semiconductor device 100 is a RC-IGBT, it can also be operated in a reverse mode, so-called diode mode. In the diode mode, the emitter electrode 2 is, for example, on ground and the collector electrode 2 is on negative potential. Electrons are injected from the collector electrode 3 into the first-type regions 15 and have to recombine with holes from the emitter electrode 2.

Without the third contact area 6c in the third base region, the only path would be through the first base region 13c via the first contact area 6a. In the case of a positive gate-emitter potential, the diode on-state losses (Vf) increase. That is because, with a positive gate-emitter potential, a channel is established between the n-type injection region 12 and the n-type drift region 14, creating an electron path. Therefore, hole injection into the first base region 13a is reduced since the electron path shorts the diode path, which results in a reduced plasma concentration.

In order to keep the diode on-state losses low, one could operate the device 100 with a negative or shorted (Vg = 0 V) gate electrode. The electron path would not be present in this case. However, this limits the usability of the device as gate-control drives and systems need to be adapted (not standard) or designed specifically for the application to achieve the lowest possible losses.

In the exemplary embodiment shown in connection with figures 1 and 2, a charge carrier path for diode operation is formed through the third base region 13c via the contact area 6c in the third base region 13c. Holes can be injected through the third contact region 6c. This charge carrier path is independent of the potential of the gate electrode, particularly since the second-type trench 52 adjacent to the third base region 13c is not at gate potential, but is at emitter potential. Therefore, operation with conventional gate drive schemes is possible while maintaining reverse recovery charge and Erec low.

The semiconductor device 100 of figures 1 and 2 further comprises an electrically conductive layer 8 on the top side 11 above the third base region 13c. The electrically conductive layer 8 is spaced apart from the semiconductor body 10 by an electrically isolating layer 80 which, in the present case, is the same as the gate insulation layer 40.

The electrically conductive layer 8 is electrically connected to the emitter electrode 2 and is so close to the third base region 13c that it capacitively couples to the third base region 13c. With the help of the electric conductive layer 8, the holes in the third base region 13c can be influenced, e.g. attracted or repelled from the electrically conductive layer 8. For example, during turn-off of the transistor mode, the holes are attracted by the conductive layer 8. In diode mode, holes may be repelled by the electrically conductive layer 8.

The electrically conductive layer 8 may be formed of highly-doped polysilicon or metal. The distance between the electrically conductive layer 8 and the third base region 13c, which is determined by the thickness of the electrically isolating layer 80 is, for example, at most 150 nm.

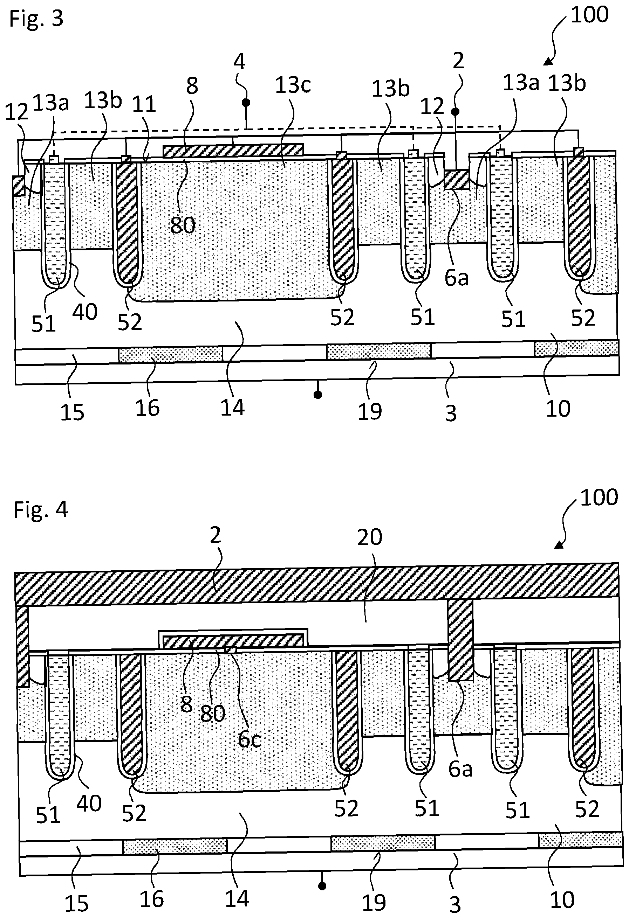

Figure 3 shows a further exemplary embodiment of the semiconductor device 100 which is similar to that of figure 1 but now without the third contact area 6c in the third base layer 13c. The electrically conductive layer 8 is not directly electrically connected to the third base region 13c but is electrically separated thereof. The functionality of the electrically conductive layer 8 is the same as in figures 1 and 2.

In the exemplary embodiment of figure 4, the gate electrode 4 and its connection to the different areas of the semiconductor device 100 are not shown in order to improve the clarity of the figure. Instead, it is shown that a portion of the emitter electrode 2 extends over the third base region 13c. The portion of the emitter electrode 2 is spaced apart from the top side 11 of the semiconductor body 10 by a further electrically isolating layer 20, herein also called "field insulating layer 20". The field insulating layer 20 may be formed of an oxide. The vertical distance between the emitter electrode 2 and the top side 11 is defined by the thickness of the field insulating layer 20 and is much larger than the thickness of the insulating layer 80 separating the electrically conductive layer 8 from the top side 11.

As can be further seen in figure 4, a portion of the electrically conductive layer 8 extends to the third base region 13c and adjoins the third base region 13c in the contact area 6c. Thus, the electrical contact between the third base region 13c and the emitter electrode 2 is established via the electrically conductive layer 8.

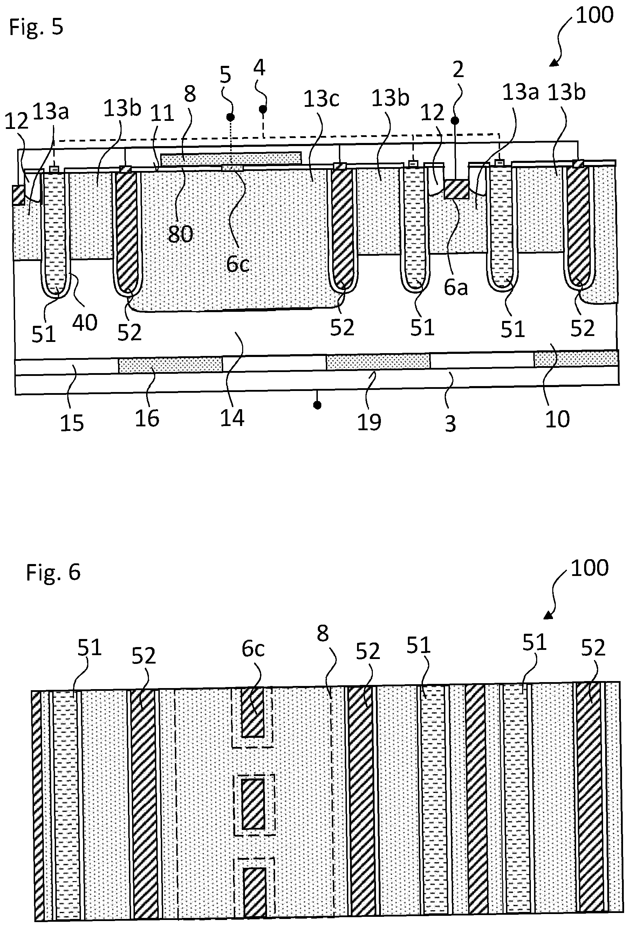

In the exemplary embodiment of figure 5, the electrically conductive layer 8 and the contact area 6c in the third base region 13c are electrically connected to an electrode 5 which is different from the emitter electrode 2 and different from the gate electrode 4. The further electrode 5 is independently controllable/biasable of the gate electrode 4 and of the emitter electrode 2. With such an electrode 5, the different operation modes of the semiconductor device 100 can be further optimized. For example, in static transistor mode, the electrode 5 can be set to a positive potential in order to repel holes from the electrically conductive layer 8 and to thereby shift the electron-hole plasma towards the active trench 51. During turn-off of the transistor mode, the further electrode 5 could be set to a negative potential in order to attract the holes. In (static) diode mode, the electrode 5 could be set to positive potential again.

Figure 6 shows an exemplary embodiment of the semiconductor device 100 in top view onto the top side 11 of the semiconductor body 10. As can be seen, the electrically conductive layer 8, indicated by the dashed line, comprises a plurality of holes, wherein each of these holes overlaps with a contact area 6c of the third base region 13c. The contact areas 6c are electrically connected to an electrode, e.g. the emitter electrode 2, through these holes in the electrically conductive layer 8. The electrically conductive layer 8 itself is formed contiguously.

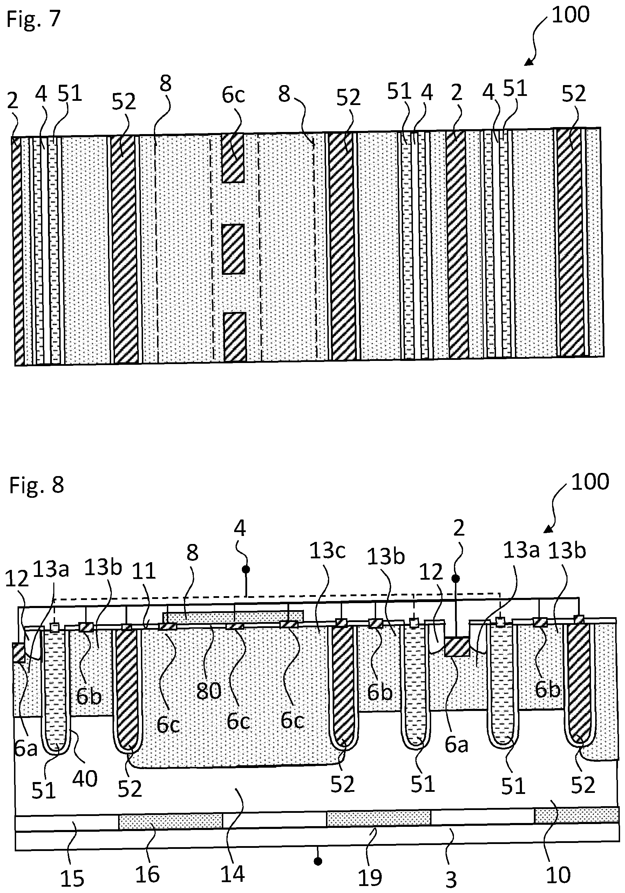

Figure 7 shows another exemplary embodiment of the semiconductor device 100, again in top view onto the top side 11. In this case, the electrically conductive layer 8 (again indicated by the dashed lines) comprises two sections which are spaced apart from each other in the first lateral direction. The gap between the two sections overlaps with the contact regions 6c of the third base region 13c.

Figure 8 shows a further exemplary embodiment of the semiconductor device 100, now again in cross-sectional view. In contrast to the previous exemplary embodiments, the third base region 13c now comprises a plurality of contact regions 6c which are spaced apart from each other in the first lateral direction. Each of these contact areas 6c is in electrical contact to the emitter electrode 2.

Moreover, the second base regions 13b each comprise contact areas 6b, also called second contact areas 6b, wherein the second base regions 13b are in electrical contact with the emitter electrode 2 in each of these contact areas 6b.

With contact areas 6b in the second base region(s) 13b, another degree of freedom for optimizing the operation of the semiconductor device 100 is available.

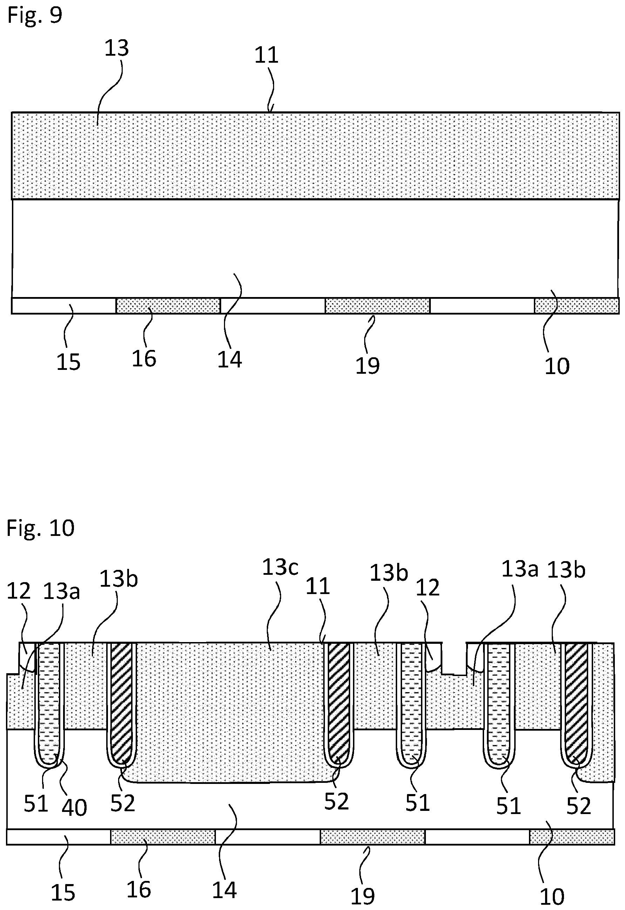

Figure 9 shows a first position in an exemplary embodiment of the method for producing a semiconductor device 100. In this position, a semiconductor body 10 with a top side 11 and a bottom side 19 is provided. The bottom side 19 is formed by first-type regions 15 and second-type regions 16 arranged in an alternating manner. The top side 11 is formed by a base region 13 being of the second conductivity type. A drift region 14 is arranged between the bottom side 19 and the base region 13, wherein the drift region 14 is of the first conductivity type.

Figure 10 shows a position after trenches 51, 52 have been formed in the semiconductor body 10. The trenches 51, 52 have been filled with electrically conductive material. The electrically conductive material in the trenches 51, 52 is electrically separated from the semiconductor body 10 by electrically isolating material 40 (gate insulation layer 40) arranged in the trenches 51, 52.

Moreover, first base regions 13a, second base regions 13b and third base regions 13c have been formed, e.g. by ion implantation. Also injection regions 12 have been formed in the semiconductor body 10, e.g. by means of ion implantation.

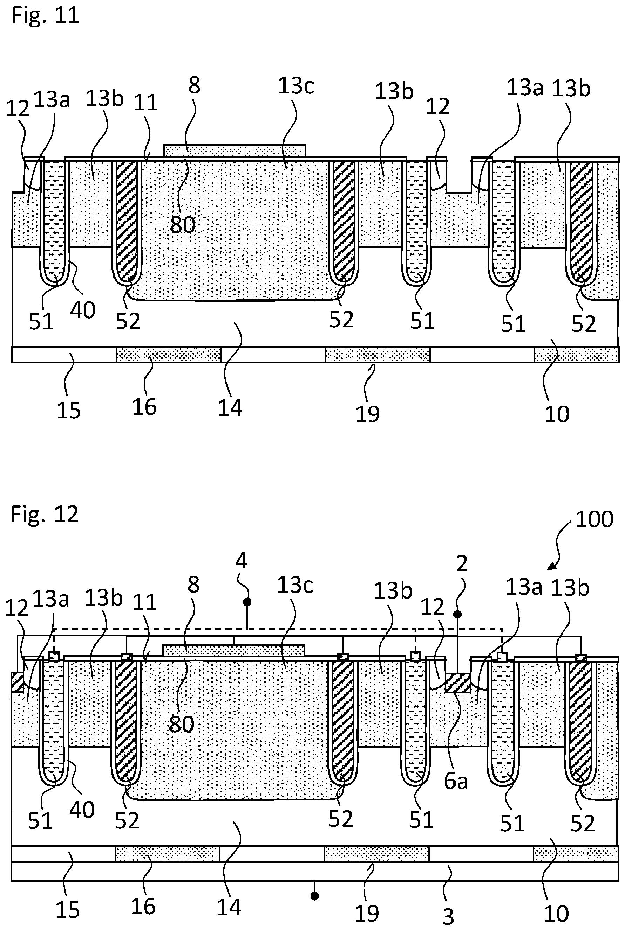

Figure 11 shows a position in which an electrically conductive layer 8 has been formed on the top side 11 above the third base region 13c. This electrically conductive layer 8 is electrically separated from the third base region 13c by an electrically isolating layer 80 which is formed of the same material as the gate insulation layer 40.

Figure 12 shows the semiconductor device 100 after the electrodes 2, 3, 4 have been applied to the semiconductor body 10. The electrically conductive layer 8 has been electrically connected to the emitter electrode 2.

The embodiments shown in the Figures 1 to 12 as stated represent exemplary embodiments of the improved semiconductor device and the improved method for producing a semiconductor device; therefore, they do not constitute a complete list of all embodiments according to the improved semiconductor device of the improved method. Actual semiconductor devices and methods may vary from the embodiments shown in terms of arrangements, elements and order of method steps, for example.

### Reference Signs

- 2: first main electrode / emitter electrode
- 3: second main electrode / collector electrode
- 4: gate electrode
- 5: further electrode
- 6a: first contact area
- 6b: second contact area
- 6c: third contact area
- 8: electrically conductive layer
- 10: semiconductor body
- 11: top side
- 12: injection region
- 13: base region
- 13a: first base region
- 13b: second base region
- 13c: third base region
- 14: drift region
- 15: first-type regions
- 16: second-type regions
- 19: bottom side
- 20: electrically isolating layer / field insulation layer
- 40: electrically isolating layer / gate insulation layer
- 51: first-type trench
- 52: second-type trench
- 80: electrically isolating layer
- 100: semiconductor device / RC-IGBT

## Claims

1. Semiconductor device (100) comprising
- a semiconductor body (10) extending in vertical direction between a top side (11) and a bottom side (19),
- a first main electrode (2) on the top side (11) and a second main electrode (3) on the bottom side (19),
- a gate electrode (4),
- at least two trenches, namely a first-type trench (51) and a second-type trench (52), each extending from the top side (11) into the semiconductor body (10), wherein
- the semiconductor body (10) comprises
- a drift region (14) of a first conductivity type arranged vertically between the top side (11) and the bottom side (19),
- at least three base regions, namely a first (13a), a second (13b) and a third (13c) base region, each of a second conductivity type and each arranged vertically between the drift region (14) and the top side (11),
- an injection region (12) of the first conductivity type vertically spaced apart from the drift region (14) by the first base region (13a) and adjoining the first base region (13a), wherein
- the first base region (13a), the first-type trench (51), the second base region (13b), the second-type trench (52) and the third base region (13c) are arranged in this order one after the other in a first lateral direction,
- the first main electrode (2) is in electrical contact with the injection region (12),
- the gate electrode (4) extends into the first-type trench (51) where it is separated from the semiconductor body (10) by a gate insulation layer (40),
- the second-type trench (52) is free of the gate electrode (4),
- an electrically conductive layer (8) is arranged on the top side (11) above the third base region (13c) and is electrically connected to an electrode (2, 5) of the semiconductor device (100) which is different from the gate electrode (4),
- the electrically conductive layer (8) is located so close to the third base region (13c) that, by electrically biasing the electrically conductive layer (8), such a strong capacitive coupling between the third base region (13c) and the electrically conductive layer (8) can be achieved that free charge carriers in the third base region (13c) are influenced thereby.

2. Semiconductor device (100) according to claim 1, wherein
- the electrically conductive layer (8) is spaced apart from the top side (11) by an electrically isolating layer (80) arranged vertically between the top side (11) and the electrically conductive layer (8),
- the thickness of the electrically isolating layer (80) is at most five times greater than the thickness of the gate insulation layer (40).

3. Semiconductor device (100) according to claim 1 or 2, wherein
- the vertical distance between the electrically conductive layer (8) and the third base region (13c) is at most 500 nm.

4. Semiconductor device (100) according to any one of the preceding claims, wherein
- the electrically conductive layer (8) and the third base region (13c) are electrically separated from each other.

5. Semiconductor device (100) according to any one of claims 1 to 3, wherein
- an electrical connection is formed between the electrically conductive layer (8) and the third base region (13c).

6. Semiconductor device (100) according to any one of the preceding claims, wherein
- in top view onto the top side (11), the electrically conductive layer (8) covers a major part of the third base region (13c).

7. Semiconductor device (100) according to any one of the preceding claims, wherein
- the electrically conductive layer (8) is arranged vertically between the top side (11) of the semiconductor body (10) and a portion of the emitter electrode (2),
- the vertical distance between the electrically conductive layer (8) and the third base region (13c) is at most half the vertical distance between the portion of the emitter electrode (2) and the top side (11) of the semiconductor body (10) .

8. Semiconductor device (100) according to any one of the preceding claims, wherein
- the semiconductor device (100) is operable in a first mode in which free charge carriers in the third base region (13c) are repelled by the electrically conductive layer (8), and/or
- the semiconductor device (100) is operable in a second mode, in which free charge carries in the third base region (13c) are attracted by the electrically conductive layer (8).

9. Semiconductor device (100) according to any one of the preceding claims, wherein
- the semiconductor device (100) is an RC-IGBT or a MISFET.

10. Semiconductor device (100) according to claims 8 and 9, wherein
- the first mode is a transistor mode, and/or
- the second mode is a diode mode.

11. Semiconductor device (100) according to any one of the preceding claims, wherein
- the third base region (13c) comprises at least one contact area (6c) in which the third base region (13c) is in electrical contact with an electrode (2, 5) of the semiconductor device (100) which is different from the gate electrode (4).

12. Semiconductor device (100) according to claim 11, wherein
- the at least one contact area (6c) and the electrically conductive layer (8) are electrically connected to the same electrode (2, 5).

13. Semiconductor device (100) according to claim 11 or 12, wherein
- the electrically conductive layer (8) comprises at least two sections which are spaced apart from one another in a lateral direction,
- the at least one contact area (6c) is arranged laterally between the two sections of the electrically conductive layer (8) .

14. Semiconductor device (100) according to any one of claims 11 to 13, wherein
- the third base region (13c) comprises a plurality of contact areas (6c), wherein the third base region (13c) is in electrical contact with the electrode (2, 5) in each of these contact areas (6c),
- the contact areas (6c) in the third base region (13c) are spaced apart from each other in at least one lateral direction.

15. Method for producing a semiconductor device (100), comprising
- providing a semiconductor body (10) with a top side (11) and a bottom side (19),
- forming at least two trenches, namely a first-type trench (51) and a second-type trench (52), each one extending from the top side (11) into semiconductor body (10),
- forming a first main electrode (2) on the top side (11) and a second main electrode (3) on the bottom side (19),
- forming a gate electrode (4) such that the gate electrode (4) extends into the first-type trench (51) where it is separated from the semiconductor body by a gate insulation layer (40), wherein
- the second-type trench (52) is kept free of the gate electrode (4),
- forming an electrically conductive layer (8) on the top side (11), wherein
- the semiconductor device (100) is formed such that the semiconductor body (10) comprises
- a drift region (14) of a first conductivity type vertically between the top side (11) and the bottom side (19),
- at least three base regions, namely a first (13a), a second (13b) and a third (13c) base region, each of a second conductivity type and each arranged vertically between the drift region (14) and the top side (11),
- an injection region (12) of the first conductivity type, vertically spaced apart from the drift region (14) by the first base region (13a) and adjoining the first base region (13a),
- the first base region (13a), the first-type trench (51), the second base region (13b), the second-type trench (52) and the third base region (13c) are arranged in this order one after the other in a first lateral direction,
- the first main electrode (2) is in electrical contact with the injection region (12),
- the electrically conductive layer (8) is arranged above the third base region (13c) and is electrically connected to an electrode (2, 5) of the semiconductor device (100) which is different from the gate electrode (4),
- the electrically conductive layer (8) is located so close to the third base region (13c) that, by electrically biasing the electrically conductive layer (8), such a strong capacitive coupling between the third base region (13c) and the electrically conductive layer (8) can be achieved that free charge carriers in the third base region (13c) are influenced thereby.
